# EUROPEAN PATENT APPLICATION

(11) **EP 2 639 953 A1**
(43) Date of publication of application: **18.09.2013**
(21) Application number: 13157736.3
(22) Date of filing: 05.03.2013
(51) Int. Cl.: H02M 7/00

(54) **Power converter apparatus**

(30) Priority: 15.03.2012 JP 2012059010
(71) Applicant: Kabushiki Kaisha Toyota Jidoshokki, Kariya-shi, Aichi 448-8671 (JP)
(72) Inventor: Inayoshi, Nobuyuki, Kariya-shi, Aichi 448-8671 (JP); Nagase, Toshiaki, Kariya-shi, Aichi 448-8671 (JP); Kanie, Naohito, Kariya-shi, Aichi 448-8671 (JP)
(74) Representative: TBK

(57) **Abstract**

A power converter apparatus includes a first substrate and a second substrate closely arranged to face each other, switching elements mounted on respective mounting surfaces of the first and second substrates, a primary and a secondary bus bars extending between the first and second substrates, an output terminal electrically connected to the primary bus bar, and two input terminals provided on the second substrate. The direction in which current flows into the first substrate and the direction in which current flows into the second substrate via the input and the output terminals are opposite to each other, and the direction in which the current flows into the primary bus bar and a direction in which the current flows into the secondary bus bar are opposite to each other. The first substrate and second substrate include heat dissipating members provided on surfaces opposite to the mounting surfaces for the switching elements.

## Description

### BACKGROUND OF THE INVENTION

The present invention relates to a power converter apparatus that includes a first substrate and a second substrate, which are closely arranged to face each other, and switching elements mounted on the substrates.

A power converter apparatus of this type is disclosed in Japanese Laid-Open Patent Publication No. 2004-311685, for example. As shown in Fig. 6, a power semiconductor device 80 of the publication has a pair of insulating substrates 81a and 81b, which face each other. An insulated gate bipolar transistor (IGBT) 82a (upper arm) and an IGBT 82b (lower arm) are mounted on circuit traces of the insulating substrates 81a and 81b, respectively. The IGBTs 82a and 82b are connected in series. A positive input terminal 83a is connected to the insulating substrate 81a, and a negative input terminal 83b is connected to the insulating substrate 81b. The channel-shaped output terminal 84 is arranged between the insulating substrates 81a and 81b, and the output terminal 84 connects the circuit traces of the insulating substrates 81a and 81b in series.

In the power semiconductor device 80, the pair of insulating substrates 81a and 81b are arranged to face each other, and the output terminal 84 connects the circuit traces of the insulating substrates 81a and 81b with each other. Accordingly, in the power semiconductor device 80, the direction of current that flows from the positive input terminal 83a into the output terminal 84 through the insulating substrate 81a is opposite to the direction of current that flows from the output terminal 84 into the negative input terminal 83b through the insulating substrate 81b. As a result, the inductance of the whole power semiconductor device 80 may be reduced by mutual induction effect. Accordingly, surge voltage accompanying switching operations of the IGBTs 82a and 82b is reduced.

In the power semiconductor device 80, since the IGBTs 82a and 82b are arranged to face each other between the pair of insulating substrates 81a and 81b, heat generated from both of the IGBTs 82a and 82b remains in the space between the insulating substrates 81a and 81b. However, measures for heat dissipation are not enough.

Accordingly, it is an object of the present invention to provide a power converter apparatus, which can regulate inductance of the whole apparatus low and improve heat dissipation property of the switching elements.

### SUMMARY OF THE INVENTION

To achieve the foregoing object and in accordance with one aspect of the present invention, a power converter apparatus including a first substrate and a second substrate closely arranged to face with each other, switching elements mounted on a mounting surface of the first substrate and a mounting surface of the second substrate, a primary bus bar extending between the first substrate and the second substrate, an output terminal electrically connected to the primary bus bar, two input terminals provided on the second substrate and a secondary bus bar arranged close to the primary bus bar with the switching elements intervened therebetween is provided. The switching elements on the first substrate and the switching elements on the second substrate are connected to each other in series. The secondary bus bar extends between the first substrate and the second substrate. One of the two input terminals is electrically connected to the secondary bus bar. Current flows into the first and the second substrates and the primary and the secondary bus bars via the input terminals and the output terminal. The direction of the current that flows into the first substrate and the direction of the current that flows into the second substrate are opposite to each other and the direction of the current that flows into the primary bus bar and the direction of the current that flows into the secondary bus bar are opposite to each other. The first substrate and the second substrate each include a heat dissipating member provided on a surface thereof opposite to the mounting surface.

According to the above configuration, the direction of the current that flows into the first substrate and the direction of the current that flows into the second substrate are opposite to each other, in which the first substrate and the second substrate are arranged close to each other. Accordingly, magnetic flux generated by the current that flows into the first substrate is balanced out by mutual induction effect by magnetic flux generated by the current that flows into the second substrate. Also, the direction of the current that flows into the primary bus bar and the direction of the current that flows into the secondary bus bar are opposite to each other, in which the primary bus bar and the secondary bus bar are arranged close to each other. Accordingly, magnetic flux generated by the current that flows into the primary bus bar is balanced out by mutual induction effect by magnetic flux generated by the current that flows into the secondary bus bar. Therefore, in the power converter apparatus, inductance in whole current paths may be regulated to be low by the mutual induction effect at a plurality of portions in the current paths. Also, in each of the first substrate and the second substrate, a heat dissipating member is provided on a surface thereof opposite to the mounting surface for the switching elements. Accordingly, since heat generated by the switching elements on each of the substrates is emitted by the corresponding heat dissipating member, the switching elements are efficiently cooled.

Other aspects and advantages of the present invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a perspective view illustrating a power converter apparatus according to an embodiment;
Fig. 2 is a side view showing the power converter apparatus of Fig. 1;
Fig. 3 is a circuit configuration diagram of the power converter apparatus of Fig. 1;
Fig. 4 is a side view showing a power converter apparatus according to another embodiment;
Fig. 5 is a side view showing a power converter apparatus according to another embodiment; and
Fig. 6 is a side view showing a conventional semiconductor device for electric power.

### DETAILED DESCRIPTION OF THE PREFERRED EMBODIMENTS

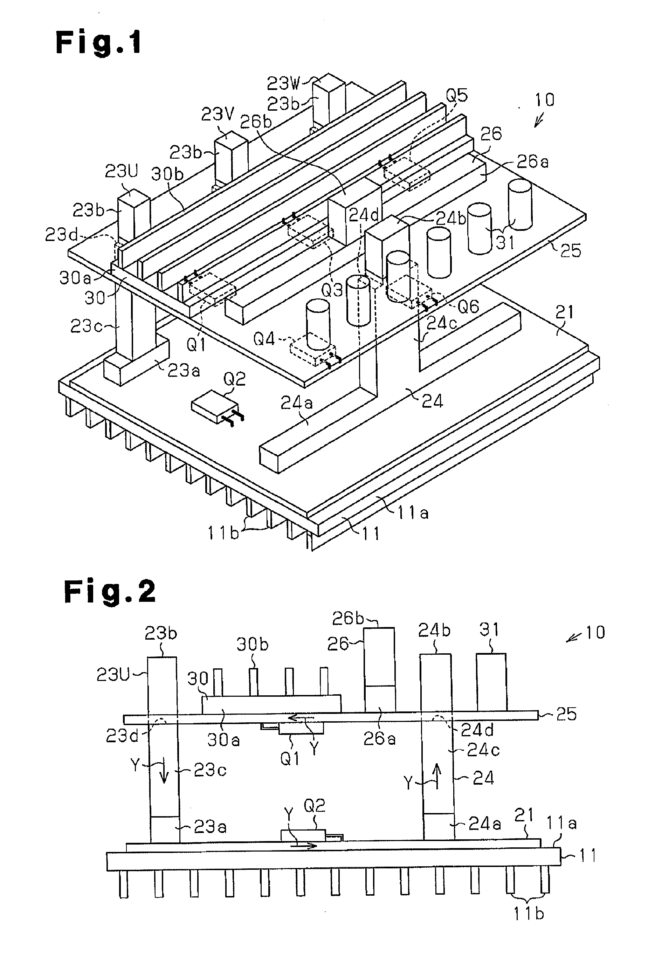

A power converter apparatus according to an embodiment of the present invention will now be described with reference to Figs. 1 to 3.

As shown in Figs. 1 and 2, a power converter apparatus 10 configures an inverter circuit of a three-phase output, for example. A first heat sink 11 provided in a lower part of the power converter apparatus 10 is formed in a rectangular plate shape from metal such as aluminum-based metal and copper. The first heat sink 11 has a rectangular plate base 11a and a plurality of fins 11b arranged side by side on the lower surface of the base 11a. A first substrate 21, which is shaped as a rectangular plate, is arranged on the upper surface of the base 11a of the first heat sink 11. The first heat sink 11 (base 11a) is thermally coupled with the first substrate 21. The direction in which the long sides of the first substrate 21 extend is defined as a longitudinal direction of the first substrate 21, and the direction in which the short sides extend is defined as a transverse direction of the first substrate 21.

An insulating substrate such as an insulating metal substrate is used as the first substrate 21. On conductive traces of the first substrate 21, a plurality of lower arm switching elements Q2, Q4 and Q6 are mounted side by side in the longitudinal direction of the first substrate 21. Power semiconductor devices such as power MOS transistors and IGBTs are used as the lower arm switching elements Q2, Q4 and Q6. Further, the lower arm switching elements Q2, Q4 and Q6 correspond to a lower arm switching element for a U-phase, a lower arm switching element for a V-phase, and a lower arm switching element for a W-phase from one of the short sides to the other one of the short sides of the first substrate 21 in this order.

Accordingly, in the present embodiment, the upper surface of the first substrate 21 is a mounting surface for the lower arm switching elements Q2, Q4 and Q6. Also, the lower surface of the first substrate 21 is a surface opposite to the mounting surface for the lower arm switching elements Q2, Q4 and Q6. The first heat sink 11 is mounted on the lower surface. Heat from the lower arm switching elements Q2, Q4 and Q6 is emitted from the first heat sink 11 via the first substrate 21. The first heat sink 11 configures a heat dissipating member.

In the vicinity of one of the long sides of the first substrate 21, a plurality of primary bus bars 23U, 23V and 23W are arranged. Specifically, the primary bus bar 23U for the U-phase, the primary bus bar 23V for the V-phase and the primary bus bar 23W for the W-phase are arranged from one of the short sides to the other one of the short sides of the first substrate 21 in this order. The primary bus bars 23U, 23V and 23W are joined onto the first substrate 21. Each of the primary bus bars 23U, 23V and 23W has a rectangular base 23a, which extends in the longitudinal direction of the first substrate 21, and a bar connection electrode portion 23c, which stands from a central portion in a longitudinal direction of the base 23a.

Further, each of the primary bus bars 23U, 23V and 23W has an output terminal 23b provided on a second substrate 25 and the connection electrode portion 23c connected to the output terminal 23b. According to the present embodiment, each of the primary bus bars 23U, 23V and 23W and the corresponding output terminal 23b are integrally formed with each other. In each of the primary bus bars 23U, and 23V and 23W, the connection electrode portion 23c located under the second substrate 25 is formed broader than the output terminal 23b located on top of the second substrate 25. Steps 23d are formed in a connection section between the connection electrode portion 23c and the output terminal 23b. Also, loads (not shown) such as a motor are connected to the output terminals 23b, which are respectively electrically connected to the corresponding primary bus bars 23U, 23V and 23W.

A secondary bus bar 24 is arranged in the vicinity of a long side of the first substrate 21 that is opposite to the long side in the vicinity of which the primary bus bars 23U, 23V and 23W are provided. This secondary bus bar 24 is joined onto the first substrate 21 and has a rectangular base 24a, which extends in the longitudinal direction of the first substrate 21, and a bar connection electrode portion 24c, which stands from a central portion in the longitudinal direction of this base 24a. Further, in the secondary bus bar 24, a negative input terminal 24b provided on the second substrate 25 is connected to the connection electrode portion 24c. According to the present embodiment, the secondary bus bar 24 and the negative input terminal 24b are integrally formed with each other. In the secondary bus bar 24, the connection electrode portion 24c located under the second substrate 25 is formed broader than the negative input terminal 24b located on top of the second substrate 25. Steps 24d are formed in a connection section between the connection electrode portion 24c and the negative input terminal 24b.

The second substrate 25, which is shaped as a rectangular plate, is supported by the steps 23d of the three primary bus bars 23U, 23V and 23W and the steps 24d of the secondary bus bar 24. The first substrate 21 and the second substrate 25 are closely arranged to face each other. That is, the primary bus bars 23U, 23V and 23W and the secondary bus bar 24 also function as spacer portions for maintaining a space between the first substrate 21 and the second substrate 25. Further, the primary bus bars 23U, 23V and 23W, more specifically, the bases 23a and the connection electrode portions 23c extend between surfaces of the first substrate 21 and the second substrate 25, which face each other. The secondary bus bar 24, more specifically, the base 24a and the connection electrode portion 24c extend between the surfaces of the first substrate 21 and the second substrate 25, which face each other. The direction in which the long sides of the second substrate 25 extend is defined as a longitudinal direction of the second substrate 25 and the direction in which the short sides extend is defined as a transverse direction of the second substrate 25.

An insulating substrate such as an insulating metal substrate is used as the second substrate 25. In the vicinity of one of the long sides of the second substrate 25, the output terminals 23b for the respective phases are arranged on the second substrate 25. Specifically, the output terminal 23b for the U-phase, the output terminal 23b for the V-phase, and the output terminal 23b for the W-phase are arranged from one of the short sides to the other one of the short sides of the second substrate 25 in this order. Further, in the vicinity of a long side of the second substrate 25 that is opposite to the long side on which the output terminals 23b are provided, the negative input terminal 24b is arranged on the upper surface of the second substrate 25. The negative input terminal 24b is located in a central portion in the longitudinal direction of the second substrate 25.

Moreover, in the second substrate 25, a positive input terminal 26 is arranged in a region sandwiched by the three output terminals 23b and the negative input terminal 24b. The positive input terminal 26 is joined onto the second substrate 25. The positive input terminal 26 has a rectangular base 26a, which extends in the longitudinal direction of the second substrate 25, and a bar positive input terminal 26b, which stands from a central portion in a longitudinal direction of this base 26a. A power supply (not shown) is connected to the positive input terminal 26 and the negative input terminal 24b.

On conductive traces of the second substrate 25, a plurality of upper arm switching elements Q1, Q3 and Q5 are mounted side by side in the longitudinal direction of the second substrate 25. Power semiconductor devices such as power MOS transistors and IGBTs are used as these upper arm switching elements Q1, Q3 and Q5. Further, the respective upper arm switching elements Q1, Q3 and Q5 correspond to an upper arm switching element for the U-phase, an upper arm switching element for the V-phase and an upper arm switching element for the W-phase from one of the short sides to the other one of the short sides of the second substrate 25 in this order. The primary bus bars 23U, 23V and 23W and the secondary bus bar 24 are closely arranged with each other with the respective switching elements Q1 to Q6 arranged therebetween.

Also, on the upper surface of the second substrate 25, namely on a surface opposite to the switching elements Q1, Q3 and Q5, a second heat sink 30 is mounted to be thermally coupled with the second substrate 25. The second heat sink 30 is formed in a rectangular plate shape from metal such as aluminum-based metal and copper. The second heat sink 30 has a rectangular plate base 30a and a plurality of fins 30b arranged on an upper surface of the base 30a side by side.

Accordingly, in the present embodiment, the lower surface of the second substrate 25 is a mounting surface for the upper arm switching elements Q1, Q3 and Q5. Also, the upper surface of the second substrate 25 is a surface opposite to the mounting surface for the upper arm switching elements Q1, Q3 and Q5, and the second heat sink 30 is mounted on the upper surface. Heat from the upper arm switching elements Q1, Q3 and Q5 is emitted from the second heat sink 30 via the second substrate 25. The second heat sink 30 configures a heat dissipating member.

Capacitors 31 are mounted on the second substrate 25. For the capacitors 31, for example, film capacitors with high capacitance or electrolytic capacitors with low capacitance that are connected in parallel, are used. In the second substrate 25, conductive traces for drains of the upper arm switching elements Q1, Q3 and Q5 for the respective phases are electrically connected to the base 26a of the positive input terminal 26. Further, in the first substrate 21, conductive traces for sources of the lower arm switching elements Q2, Q4 and Q6 for the respective phases are electrically connected to the base 24a of the secondary bus bar 24. Moreover, the positive terminals of the capacitors 31 are connected to the positive input terminal 26 via positive conductive traces, and negative terminals of the capacitors 31 are connected to the secondary bus bar 24 via negative conductive traces.

The second substrate 25 and first substrate 21 are electrically connected with each other by the primary bus bars 23U, 23V and 23W and the secondary bus bar 24. Specifically, between two input terminals, namely, the positive input terminal 26 and the negative input terminal 24b mounted on the second substrate 25, the upper arm switching element Q1 and the lower arm switching element Q2 for the U-phase are connected in series by the primary bus bar 23U for the U-phase and the secondary bus bar 24. Further, the upper arm switching element Q3 and the lower arm switching element Q4 for the V-phase are connected in series by the primary bus bar 23V for the V-phase and the secondary bus bar 24. Moreover, the upper arm switching element Q5 and the lower arm switching element Q6 for the W-phase are connected in series by the primary bus bar 23W for the W-phase and the secondary bus bar 24.

In the power converter apparatus 10, current from a power supply flows from the positive input terminal 26 to the capacitors 31 through the conductive traces of the second substrate 25 and to the upper arm switching elements Q1, Q3 and Q5 to be supplied to loads such as a motor via the output terminals 23b for the respective phases. Accordingly, in the second substrate 25, as shown by a top arrow Y in Fig. 2, the current flows from right to left, namely from the positive input terminal 26 to the primary bus bars 23U, 23V and 23W.

Then, the current returned from the loads flows from the output terminals 23b for the respective phases to the primary bus bars 23U, 23V and 23W for the corresponding phases, namely, from top to bottom and to the lower arm switching elements Q2, Q4 and Q6 via the conductive traces of the first substrate 21. Thereafter, the current flows through the secondary bus bar 24 from the bottom to the top via the conductive traces of the first substrate 21 into the negative input terminal 24b. Accordingly, in the first substrate 21, as shown by a bottom arrow Y in Fig. 2, the current flows from left to right, namely, from the primary bus bars 23U, 23V and 23W to the negative input terminal 24b. Therefore, as shown by the arrows Y in Fig. 2, the direction of the current that flows into the second substrate 25, and the direction of the current that flows into the first substrate 21 are opposite to each other. Also, the direction of the current that flows through each of the primary bus bars 23U, 23V and 23W and the direction of the current that flows into the secondary bus bar 24 are opposite to each other.

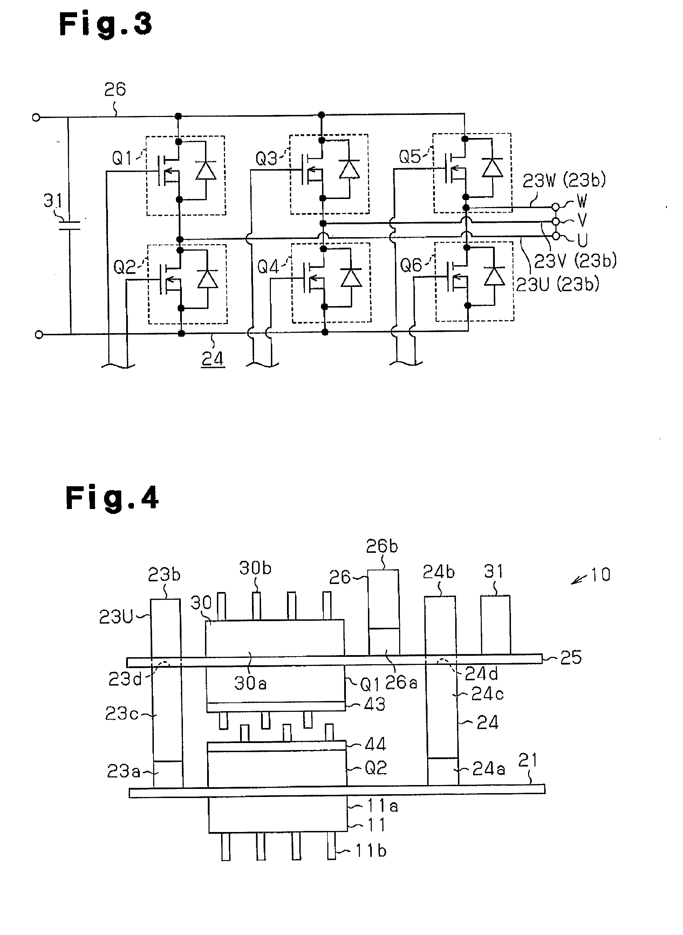

Next, a circuit configuration of the power converter apparatus 10 will be described. As shown in Fig. 3, an inverter circuit has six switching elements Q1 to Q6. In the inverter circuit, the upper arm switching element Q1 for the U-phase and the lower arm switching element Q2 for the U-phase are connected in series, the upper arm switching element Q3 for the V-phase and the lower arm switching element Q4 for the V-phase are connected in series, and the upper arm switching element Q5 for the W-phase and the lower arm switching element Q6 for the W-phase are connected in series.

In the inverter circuit, the conductive traces for the drains of the upper arm switching elements Q1, Q3 and Q5 for the U-phase, the V-phase and the W-phase are electrically connected to the positive input terminal 26. Further, the conductive traces for the sources of the lower arm switching elements Q2, Q4 and Q6 for the U-phase, the V-phase and the W-phase are electrically connected to the secondary bus bar 24.

Moreover, the capacitors 31 are connected between the positive input terminal 26 and the secondary bus bar 24. In order to simplify the description of the inverter circuit, Fig. 3 shows the capacitors 31. As current from the power supply flows from the positive input terminal 26 into the capacitors 31, the capacitors 31 are charged. If the capacitors 31 are charged, current is supplied from the capacitors 31 to the loads via the respective switching elements Q1 to Q6.

A connection point between the upper arm switching element Q1 for the U-phase and the lower arm switching element Q2 for the U-phase is connected to an output terminal U for the U-phase via the output terminal 23b of the primary bus bar 23U for the U-phase. A connection point between the upper arm switching element Q3 for the V-phase and the lower arm switching element Q4 for the V-phase is connected to an output terminal V for the V-phase via the output terminal 23b of the primary bus bar 23V for the V-phase. A connection point between the upper arm switching element Q5 for the W-phase and the lower arm switching element Q6 for the W-phase is connected to an output terminal W for the W-phase via the output terminal 23b of the primary bus bar 23W for the W-phase. Loads such as a motor are connected to the output terminal U for the U-phase, the output terminal V for the V-phase and the output terminal W for the W-phase.

Next, the operation of the power converter apparatus 10 with the above described configuration will now be described.

As direct current from the power supply flows from the positive input terminal 26 to the capacitors 31 and into the upper arm switching elements Q1, Q3 and Q5 and the lower arm switching elements Q2, Q4 and Q6, the switching elements Q1 to Q6 are respectively controlled to be turned on and off at predetermined intervals. Then, alternating current is supplied to the loads such as a motor via the output terminal U for the U-phase, the output terminal V for the V-phase and the output terminal W for the W-phase. The current flows from the secondary bus bar 24 into the power supply. Alternatively, regenerative current from the loads such as a motor flows into the upper arm switching elements Q1, Q3 and Q5 and the lower arm switching elements Q2, Q4 and Q6 and the switching elements Q1 to Q6 are respectively controlled to be turned on and off at predetermined intervals. The regeneration current flows into the capacitors 31 and from the positive input terminal 26 into the secondary bus bar 24 via the power supply.

Further, the first substrate 21 and second substrate 25, which are arranged to face each other, are connected by the primary bus bars 23U, 23V and 23W and the secondary bus bar 24. Thereby, the direction of the current that flows into the first substrate 21 and the direction of the current that flows into the second substrate 25 are opposite to each other. Also, the direction of the current that flows into the primary bus bars 23U, 23V and 23W and the direction of the current that flows through the secondary bus bar 24 are opposite to each other. In the power converter apparatus 10, as the upper arm switching elements Q1, Q3 and Q5 are heated by switching operations, the heat is emitted from the second heat sink 30 via the second substrate 25. Also, as the lower arm switching elements Q2, Q4 and Q6 are heated by switching operations, the heat is emitted from the first heat sink 11 via the first substrate 21.

According to the above described embodiments, the following advantages are obtained.
(1) The first substrate 21 and the second substrate 25 are closely arranged to face each other. Also, the primary bus bars 23U, 23V and 23W and the secondary bus bar 24 are arranged close to each other. Also, the direction of the current that flows into the first substrate 21 and the direction of the current that flows into the second substrate 25 are opposite to each other, and the direction of the current that flows into the primary bus bars 23U, 23V and 23W and the direction of the current that flows into the secondary bus bar 24 are opposite to each other. Accordingly, magnetic flux generated by the currents that flow in the directions opposite to each other is balanced out by mutual induction effect so that the inductance in the whole current paths is regulated to be low. As a result, even if the switching operations of the respective switching elements Q1 to Q6 are performed rapidly, surge voltage is regulated to be low. Accordingly, it is not necessary to increase the breakdown voltage of the respective switching elements Q1 to Q6. Therefore, switching elements at a low cost can be adopted as the respective switching elements Q1 to Q6. Since the switching loss of the respective switching elements Q1 to Q6 is reduced, generation of heat by the respective switching elements Q1 to Q6 is also be suppressed.
(2) In the first substrate 21 and second substrate 25, the heat sinks 11 and 30 are provided on a side opposite to the mounting surface for the respective switching elements Q1 to Q6. Accordingly, the upper arm switching elements Q1, Q3 and Q5 can be individually cooled by the second heat sink 30, and the lower arm switching elements Q2, Q4 and Q6 can be individually cooled by the first heat sink 11.
(3) The upper arm switching elements Q1, Q3 and Q5 and the lower arm switching elements Q2, Q4 and Q6 are arranged on the surfaces of the first and the second substrates 21, 25, which face each other. The first heat sink 11 is provided on an outer surface of the first substrate 21 and is exposed to an outside of the power converter apparatus 10. The second heat sink 30 is provided on an outer surface of the second substrate 25 and is exposed to the outside of the power converter apparatus 10. Therefore, even if the upper arm switching elements Q1, Q3 and Q5 and the lower arm switching elements Q2, Q4 and Q6 are arranged in a space between the surfaces of the first and the second substrates 21, 25 to face each other, heat generated by the respective switching elements Q1 to Q6 is efficiently emitted to the outside of the power converter apparatus 10 by the corresponding heat sinks 11 and 30. As a result, the heat sinks 11 and 30, which are provided on both of the substrates 21 and 25, prevent the heat from being retained in the space between the first substrate 21 and the second substrate 25, thereby efficiently cooling the respective switching elements Q1 to Q6.
(4) The output terminals 23b for the respective phases, the negative input terminal 24b and the positive input terminal 26 are arranged on the second substrate 25. That is, three of the terminals are collectively arranged on the single second substrate 25. Accordingly, for example, compared with a case where the output terminals 23b, the negative input terminal 24b and the positive input terminal 26 are separately arranged on the first substrate 21 and the second substrate 25, operations for connecting wires such as wire harness to the respective terminals can be easily performed.
(5) In the power converter apparatus 10, the first substrate 21 and the second substrate 25 are closely arranged to face each other and the upper arm switching elements Q1, Q3 and Q5 and the lower arm switching elements Q2, Q4 and Q6 are connected by the primary bus bars 23U, 23V and 23W in series. Accordingly, compared with a case where the upper arm switching elements Q1, Q3 and Q5 and the lower arm switching elements Q2, Q4 and Q6 are arranged on a single substrate to be respectively connected in series, a current path is shortened to suppress self-inductance. Therefore, the current path is shortened to suppress the self-inductance, and the directions of the flowing current are inversed to utilize mutual induction effect so that the inductance of the whole power converter apparatus 10 is suppressed to be low.
(6) The output terminals 23b are integrally formed with the corresponding primary bus bars 23U, 23V and 23W. Accordingly, for example, compared with a case where the primary bus bars 23U, 23V and 23W are separate from the output terminals 23b, the number of parts of the power converter apparatus 10 is reduced.

The above described embodiments may be modified as follows.

According to the above described embodiment, the upper arm switching elements Q1, Q3 and Q5 are provided on the lower surface (mounting surface) of the second substrate 25 and the second heat sink 30 is provided on the upper surface of the second substrate 25. Also, the upper arm switching elements Q2, Q4 and Q6 are provided on the upper surface (mounting surface) of the first substrate 21 and the first heat sink 11 is provided on the lower surface of the first substrate 21. Such an arrangement is not limited to the above described embodiment, however. The mounting surfaces of the substrates 21, 25 for the respective switching elements Q1 to Q6 and the surfaces on which the respective heat sinks 11 and 30 are provided may be changed.

As shown in Fig. 4, in a manner similar to that of the above described embodiment, the upper arm switching elements Q1, Q3 and Q5 may be mounted on the lower surface (mounting surface) of the second substrate 25 and the second heat sink 30 may be provided on the upper surface of the second substrate 25. In the upper arm switching elements Q1, Q3 and Q5, a heat dissipating member 43 may be thermally coupled with surfaces (lower surfaces) opposite to joining surfaces (upper surfaces) of the switching elements Q1, Q3 and Q5 to be joined with the second substrate 25.

Also, in the first substrate 21, in a manner similar to that of the above described embodiment, the lower arm switching elements Q2, Q4 and Q6 may be mounted on the upper surface (mounting surface) of the first substrate 21 and the first heat sink 11 may be provided on the lower surface of the first substrate 21. In the lower arm switching elements Q2, Q4 and Q6, a heat dissipating member 44 may be thermally coupled with surfaces (upper surfaces) opposite to joining surfaces (lower surfaces) of the switching elements Q2, Q4 and Q6 to be joined with the first substrate 21.

As configured in this manner, the upper arm switching elements Q1, Q3 and Q5 are sandwiched by the second heat sink 30 and the heat dissipating member 43 to improve heat dissipating property. Also, the lower arm switching elements Q2, Q4 and Q6 are sandwiched by the first heat sink 11 and the heat dissipating member 44 to improve heat dissipating property.

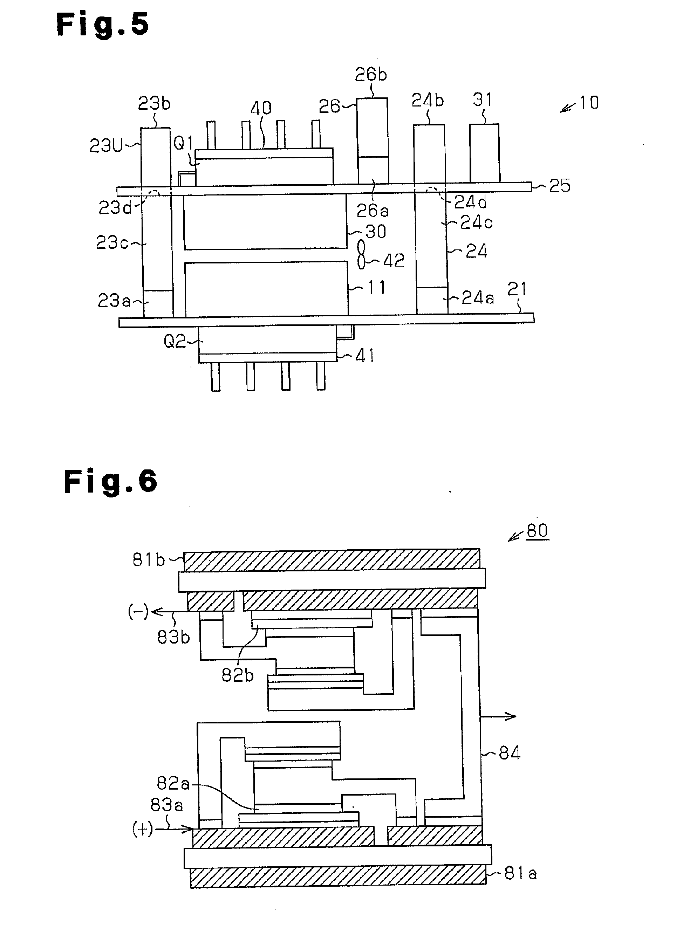

Further, as shown in Fig. 5, the upper arm switching elements Q1, Q3 and Q5 may be mounted on the upper surface (mounting surface) of the second substrate 25, and a heat dissipating member 40 may be thermally coupled with the surfaces opposite to the joining surfaces of the upper arm switching elements Q1, Q3 and Q5 to be joined with the second substrate 25. Upon this, the second heat sink 30 is provided on the lower surface (the surface opposite to the mounting surface) of the second substrate 25.

Also, the lower arm switching elements Q2, Q4 and Q6 may be mounted on the lower surface (mounting surface) of the first substrate 21, and a heat dissipating member 41 may be thermally coupled with the surfaces opposite to the joining surfaces of the lower arm switching elements Q2, Q4 and Q6 to be joined with the first substrate 21. Upon this, the first heat sink 11 is provided on the upper surface (the surface opposite to the mounting surface) of the first substrate 21. In this case, in order to prevent heat from being retained between the first heat sink 11 and the second heat sink 30, it is preferable to provide a fan 42 or a cooler (not shown) in place of the first heat sink 11 and the second heat sink 30.

As configured above, in addition to the heat sinks 11 and 30 provided on the substrates 21 and 25, respectively, the heat generated by the respective switching elements Q1 to Q6 may be emitted by the heat dissipating members 40 and 41 provided on the switching elements Q1 to Q6. Accordingly, since the two heat dissipating members are thermally coupled with the single switching element, the respective switching elements Q1 to Q6 may be efficiently cooled.

In the above embodiment, although the output terminals 23b, the negative input terminal 24b and the positive input terminal 26 are arranged on the second substrate 25, the output terminals 23b, the negative input terminal 24b and positive input terminal 26 may be distributed to the first substrate 21 and the second substrate 25, respectively or collectively arranged on the first substrate 21 as long as electrical connection is maintained.

According to the above described embodiment, the capacitors 31 are mounted on the second substrate 25. The capacitors, however, may be distributed to the first substrate 21 and second substrate 25 separately corresponding to the upper arm and the lower arm switching elements or may be mounted on the first substrate 21 only.

In the above embodiment, the lower arm switching elements Q2, Q4 and Q6 are mounted on the first substrate 21 and the upper arm switching elements Q1, Q3 and Q5 are mounted on the second substrate 25. The mounting configuration, however, is not limited to this. The upper arm switching elements Q1, Q3 and Q5 may be mounted on the first substrate 21 and the lower arm switching elements Q2, Q4 and Q6 may be mounted on the second substrate 25.

In the above described embodiment, the output terminals 23b are integrally formed with the corresponding primary bus bars 23U, 23V and 23W. The output terminals 23b, however, may be separate from the primary bus bars 23U, 23V and 23W. That is, the primary bus bars 23U, 23V and 23W respectively connect the upper arm switching elements Q1, Q3 and Q5 and the lower arm switching elements Q2, Q4 and Q6 in series. As long as the output terminals 23b are electrically connected to the primary bus bars 23U, 23V and 23W, positions or forms of the output terminals 23b may be modified as necessary.

In the above described embodiment, the negative input terminal 24b is integrally formed with the secondary bus bar 24. The negative input terminal 24b, however, may be separate from the secondary bus bar 24.

In the above described embodiment, the negative input terminal 24b is electrically connected to the secondary bus bar 24. The positive input terminal 26, however, may be electrically connected to the secondary bus bar 24 in place of the negative input terminal 24b.

Therefore, the present examples and embodiments are to be considered as illustrative and not restrictive and the invention is not to be limited to the details given herein, but may be modified within the scope and equivalence of the appended claims.

A power converter apparatus includes a first substrate and a second substrate closely arranged to face each other, switching elements mounted on respective mounting surfaces of the first and second substrates, a primary and a secondary bus bars extending between the first and second substrates, an output terminal electrically connected to the primary bus bar, and two input terminals provided on the second substrate. The direction in which current flows into the first substrate and the direction in which current flows into the second substrate via the input and the output terminals are opposite to each other, and the direction in which the current flows into the primary bus bar and a direction in which the current flows into the secondary bus bar are opposite to each other. The first substrate and second substrate include heat dissipating members provided on surfaces opposite to the mounting surfaces for the switching elements.

## Claims

1. A power converter apparatus comprising:
a first substrate (21) and a second substrate (25) closely arranged to face each other;
switching elements (Q1-Q6) mounted on a mounting surface of the first substrate (21) and a mounting surface of the second substrate (25), the switching elements (Q2, Q4, Q6) on the first substrate (21) and the switching elements (Q1, Q3, Q5) on the second substrate (25) being connected to each other in series;
a primary bus bar (23U, 23V, 23W) extending between the first substrate (21) and the second substrate (25);
an output terminal (23b) electrically connected to the primary bus bar (23U, 23V, 23W);
two input terminals (24b, 26b) provided on the second substrate (25); and
a secondary bus bar (24) arranged close to the primary bus bar (23U, 23V, 23W) with the switching elements (Q1-Q6) arranged therebetween, the secondary bus bar (24) extending between the first substrate (21) and the second substrate (25),
the power converter apparatus being **characterized in that**
one of the two input terminals (24b, 26b) is electrically connected to the secondary bus bar (24),
current flows into the first and the second substrates (21, 25) and the primary and the secondary bus bars (23U, 23V, 23W, 24) via the input terminals (24b, 26b) and the output terminal (23b),
a direction of the current that flows into the first substrate (21) and a direction of the current that flows into the second substrate (25) are opposite to each other, and a direction of the current that flows into the primary bus bar (23U, 23V, 23W) and a direction of the current that flows into the secondary bus bar (24) are opposite to each other, and
the first substrate (21) and the second substrate (25) each include a heat dissipating member (11, 30; 40, 41; 43, 44) provided on a surface thereof opposite to the mounting surface.

2. The power converter apparatus according to claim 1, wherein the mounting surface of the first substrate (21) and the mounting surface of the second substrate (25) face each other.

3. The power converter apparatus according to claim 1 or 2, wherein
the heat dissipating members are primary heat dissipating members (11, 30),
the switching elements (Q1-Q6) each include a joining surface joined with the corresponding substrate (21, 25), and
a second heat dissipating member (40, 41; 43, 44) is thermally coupled with a surface opposite to the joining surface of each switching element.

4. The power converter apparatus according to claim 1 or 2, wherein all of the two input terminals (24b, 26b) and the output terminal (23b) are arranged on the second substrate (25).

5. The power converter apparatus according to claim 1 or 2, wherein the output terminal (23b) is integrally formed with the primary bus bar (23U, 23V, 23W).

6. The power converter apparatus according to claim 1 or 2, wherein the heat dissipating member (11; 41) provided on the first substrate (21) and the heat dissipating member (30; 40) provided on the second substrate (25) are exposed to outside.
